# EUROPEAN PATENT APPLICATION

(11) **EP 4 231 351 A1**
(43) Date of publication of application: **23.08.2023**
(21) Application number: 23155838.8
(22) Date of filing: 09.02.2023
(51) Int. Cl.: H01L 25/16, H01L 23/00, H01L 25/00, H01L 27/06, H01L 29/94, H01L 23/498, H01L 23/522, H01L 25/065, H01L 25/10, H01L 25/18

(54) **SEMICONDUCTOR PACKAGES**

(30) Priority: 17.02.2022 US 202263311099 P; 07.10.2022 US 202217962185
(71) Applicant: MediaTek Inc., Hsinchu City 30078 (TW)
(72) Inventor: CHEN, Hsiao-Yun, 30078 Hsinchu City (TW); HUANG, Chi-Hung, 30078 Hsinchu City (TW); HUANG, Yao-Tsung, 30078 Hsinchu City (TW); CHANG, Cheng-Jyi, 30078 Hsinchu City (TW); CHANG, Sheng-Chieh, 30078 Hsinchu City (TW)
(74) Representative: Goddar, Heinz J.

(57) **Abstract**

Various embodiments of a 3DIC die package, including trench capacitors integrated with IC dies, are disclosed. A 3DIC die package includes a first IC die and a second IC die disposed on the first IC die. The first IC die includes a substrate having a first surface and a second surface opposite to the first surface, a first active device disposed on the first surface of the substrate, and a passive device disposed on the second surface of the substrate. The passive device includes a plurality of trenches disposed in the substrate and through the second surface of the substrate, first and second conductive layers disposed in the plurality of trenches and on the second surface of the substrate, and a first dielectric layer disposed between the first and second conductive layers. The second IC die includes a second active device.

## Description

### CROSS-REFERENCE TO RELATED APPLICATION

This application claims the benefit of U.S. Provisional Patent Application No. 63/311,099, titled "System Performance Enhancement with Chiplet Architecture Utilizing Advanced 3D Stacking Package," filed on February 17, 2022, the disclosure of which is incorporated by reference herein in its entirety.

### FIELD

This disclosure relates to semiconductor packages and, more particularly, to three-dimensional integrated circuit (3DIC) die packages.

### BACKGROUND

A 3DIC die package can include two or more IC dies (e.g., system-on-chips SOCs), logic dies, and/or memory dies) stacked vertically to increase device density and reduce die package size. Power and signal connections between the vertically stacked IC dies can be made using through-vias (e.g., through-silicon vias (TSVs) and/or through-dielectric vias (TDVs)). One or more of the IC chips can include one or more decoupling capacitors with a metal-insulator-metal (MIM) capacitor structure. The decoupling capacitors can mitigate power line ripple (e.g., current fluctuations) and can provide electromagnetic (EM) shielding for EM emissions from adjacent devices in the IC chips.

### SUMMARY

Various embodiments of a 3DIC die package, including trench capacitors (also referred to as "deep trench capacitors") integrated with IC dies, are disclosed. In some embodiments, a structure includes a first IC die and a second IC die disposed on the first IC die. The first IC die includes a substrate having a first surface and a second surface opposite to the first surface, a first active device disposed on the first surface of the substrate, and a passive device disposed on the second surface of the substrate. The passive device includes a plurality of trenches disposed in the substrate and through the second surface of the substrate, first and second conductive layers disposed in the plurality of trenches and on the second surface of the substrate, and a first dielectric layer disposed between the first and second conductive layers. The second IC die includes a second active device.

In some embodiments, a structure includes a first IC die and a second IC die disposed on the first IC die. The first IC die includes a first active device disposed on a first substrate. The second IC die includes an active die, a passive die, and a hybrid bond interface. The hybrid bond interface includes a conductive interface between metal pads of the active and passive dies and a non-conductive interface between dielectric layers of the active and passive dies. The active die includes a second active device disposed on a second substrate. The passive die includes a passive device disposed on a first surface of a third substrate. The passive device includes a plurality of trenches disposed in the third substrate, a first capacitor, and a second capacitor. The first capacitor includes a first conductive layer disposed in the plurality of trenches and a doped region surrounding the plurality of trenches. The second capacitor includes the first conductive layer and a second conductive layer disposed on the first conductive layer.

In some embodiments, a method includes forming a passive die with a capacitor in a first substrate, forming an active die with an active device in a second substrate, performing a plasma process on top surfaces of the active and passive dies, placing the active die on the passive die with the top surface of the active die facing the top surface of the passive die, forming a hybrid bond at an interface between the top surfaces of the active and passive dies to form a hybrid die with the active and passive dies, and bonding the hybrid die to an other active die.

### BRIEF DESCRIPTION OF THE DRAWINGS

Aspects of this disclosure are best understood from the following detailed description when read with the accompanying figures.
Figs. 1A and 1B illustrate cross-sectional views of a 3DIC die package with trench capacitors in an IC die, in accordance with some embodiments.
Figs. 2A and 2B illustrate cross-sectional views of a 3DIC die package with a trench capacitor die hybrid bonded to an IC die, in accordance with some embodiments.
Fig. 3 illustrates a cross-sectional view of a 3DIC die package with trench capacitors in an IC die and a trench capacitor die bonded to an IC die, in accordance with some embodiments.
Fig. 4 is a flow diagram of a method for fabricating a 3DIC die package with trench capacitors in an IC die, in accordance with some embodiments.
Figs. 5-12 illustrate cross-sectional views of a 3DIC die package with trench capacitors in an IC die at various stages of its fabrication process, in accordance with some embodiments.
Figs. 13-16 illustrate cross-sectional views of different configurations of 3DIC die packages with trench capacitors in IC dies, in accordance with some embodiments.
Fig. 17 is a flow diagram of a method for fabricating a 3DIC die package with a trench capacitor die hybrid bonded to an IC die, in accordance with some embodiments.
Figs. 18-22 illustrate cross-sectional views of a 3DIC die package with a trench capacitor die hybrid bonded to an IC die at various stages of its fabrication process, in accordance with some embodiments.
Figs. 23-24 illustrate cross-sectional views of different configurations of 3DIC die packages with trench capacitor dies hybrid bonded to IC dies, in accordance with some embodiments.

Illustrative embodiments will now be described with reference to the accompanying drawings. In the drawings, like reference numerals generally indicate identical, functionally similar, and/or structurally similar elements. The discussion of elements with the same annotations applies to each other, unless mentioned otherwise.

### DETAILED DESCRIPTION

The following disclosure provides many different embodiments, or examples, for implementing different features of the provided subject matter. Specific examples of components and arrangements are described below to simplify the present disclosure. These are, of course, merely examples and are not intended to be limiting. For example, the process for forming a first feature over a second feature in the description that follows may include embodiments in which the first and second features are formed in direct contact, and may also include embodiments in which additional features may be formed between the first and second features, such that the first and second features may not be in direct contact. As used herein, the formation of a first feature on a second feature means the first feature is formed in direct contact with the second feature. In addition, the present disclosure may repeat reference numerals and/or letters in the various examples. This repetition does not in itself dictate a relationship between the various embodiments and/or configurations discussed.

Spatially relative terms, such as "beneath," "below," "lower," "above," "upper," and the like may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

It is noted that references in the specification to "one embodiment," "an embodiment," "an example embodiment," "exemplary," etc., indicate that the embodiment described may include a particular feature, structure, or characteristic, but every embodiment may not necessarily include the particular feature, structure, or characteristic. Moreover, such phrases do not necessarily refer to the same embodiment. Further, when a particular feature, structure or characteristic is described in connection with an embodiment, it would be within the knowledge of one skilled in the art to effect such feature, structure or characteristic in connection with other embodiments whether or not explicitly described.

It is to be understood that the phraseology or terminology herein is for the purpose of description and not of limitation, such that the terminology or phraseology of the present specification is to be interpreted by those skilled in relevant art(s) in light of the teachings herein.

In some embodiments, the terms "about" and "substantially" can indicate a value of a given quantity that varies within 5 % of the value (e.g., ±1 %, ±2 %, ±3 %, ±4 %, ±5 % of the value). These values are merely examples and are not intended to be limiting. The terms "about" and "substantially" can refer to a percentage of the values as interpreted by those skilled in relevant art(s) in light of the teachings herein.

Electronic devices, such as computers, mobile phones, cameras, watches, and tablets include IC die packages. The scaling down of IC die packages to meet the increasing demand for smaller electronic devices led to the development of 3DIC packaging technology, which vertically stacks two or more IC dies in a 3DIC die package. The electrical connections between the vertically stacked IC dies are made using through-vias in the IC dies and/or through-vias in interposer structures disposed between the vertically stacked IC dies.

The increased device density in 3DIC die packages requires higher average and transient current, which increases the power supply noise in 3DIC die packages. To control the power supply noise for stable power delivery, 3DIC die packages use decoupling capacitors, which reduce the impedance of power distribution systems in 3DIC die packages to support the load of the integrated circuits more dynamically and to reduce power supply noise. The decoupling capacitors can be integrated in the interconnect structures of the IC dies and/or in the interposer structures between the vertically stacked IC dies. However, the continued miniaturization of electronic devices increases the challenges of manufacturing decoupling capacitors in the interconnect structures and interposers that can meet the size constraints and the power integrity requirements of 3DIC die packages.

The present disclosure provides example 3DIC die packages with trench capacitors integrated with IC dies and example methods of fabricating 3DIC die packages. In some embodiments, the 3DIC die package can include a system-on-chip (SoC) die stacked on an IC die (e.g., logic die or memory die) and a redistribution layer disposed between the SoC die and the IC die to provide electrical connections between them. In some embodiments, the IC die can include active devices (e.g., transistors) and trench capacitors that can function as decoupling capacitors. The active devices can be formed on a first surface (also referred to as a "front-side surface") of a substrate of the IC die and the trench capacitors can be formed on a second surface (also referred to as a "back-side surface") of the substrate. In some embodiments, each of the trench capacitor can include two or more capacitors stacked over one another in a metal-insulator-metal (MIM) configuration in a trench in the second surface of the substrate. The two or more of the stacked capacitors are electrically connected in a parallel configuration.

In some embodiments, the trench capacitors can be integrated with the SoC die instead of the IC die or in addition to the IC die. In some embodiments, the trench capacitors can be integrated with the SoC die by hybrid bonding the SoC die with a passive die, including the trench capacitors along with TSVs. The hybrid bond between the SoC die and the passive die can include metal-to-metal bonds (e.g., copper-to-copper bonds) and non-metal-to-non-metal bonds (e.g., oxide-to-oxide bonds).

In some embodiments, the trench capacitors can be integrated in the IC dies in addition to or instead of the capacitors in the interconnect structures and/or in the interposer structures. With the integration of the trench capacitors in the IC dies, the capacitance density of 3DIC die package can be increased without increasing the number of capacitors in the interconnect structures and/or in the interposer structures and/or without increasing the number of interposers with capacitors in the 3DIC die package. In addition, as the trench capacitors extend into the trenches in the substrate, the trench capacitors can occupy less surface area of the substrate than planar MIM capacitors in the interconnect structures of IC dies to achieve the same capacitance densities. For example, a standard cell unit of trench capacitors can occupy an area of about 40 × 40 um² on the surface of the substrate, which is less than the area of about 60 × 210 um² occupied by a standard cell unit of planar MIM capacitors. In addition, the capacitance density achieved with the trench capacitors can be about 20 times more than that achieved with planar MIM capacitors occupying the same surface areas of the substrate. Thus, with the integration of the trench capacitors in the substrate of the IC dies, the capacitance density of the 3DIC die package can be increased to meet the ever-increasing demand for enhanced power delivery and power integrity in 3DIC die packages without compromising the die package size.

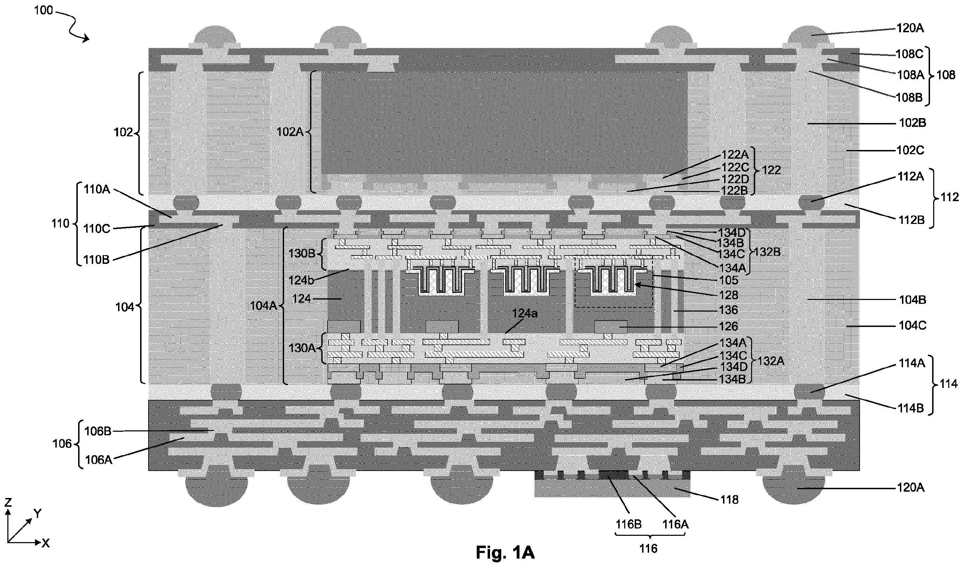

Fig. 1A illustrates a cross-sectional view of a 3DIC die package 100, according to some embodiments. In some embodiments, 3DIC die package 100 can include (i) a first die layer 102, (ii) a second die layer 104, (iii) a package substrate 106, (iv) redistribution layers (RDLs) 108 and 110, (v) bonding layers 112, 114, and 116, (vi) an integrated passive device (IPD) 118, and (vii) conductive bonding structures 120A and 120B. First die layer 102 can be disposed on second die layer 104, which can be disposed on package substrate 106. In some embodiments, first die layer 102 can be electrically bonded to underlying second die layer 104 with redistribution layer 110 and bonding layer 112. Similarly, in some embodiments, second die layer 104 can be electrically bonded to underlying package substrate 106 with bonding layer 114. In some embodiments, first die layer 102 can be electrically bonded to overlying die layers (not shown) with redistribution layer 108.

In some embodiments, bonding layer 112 can include conductive bonding structures 112A and underfill layer 112B, and bonding layer 114 can include conductive bonding structures 114A and underfill layer 114B. In some embodiments, conductive bonding structures 112A and 114A can include solder bumps, copper (Cu) bumps, Cu pillars, or any other suitable conductive bonding structures. In some embodiments, underfill layers 112B and 114B can include a molding compound, an epoxy, a resin, or any other encapsulating compound. Underfill layers 112B and 114B can provide mechanical support to conductive bonding structures 112A and 114B, respectively. Underfill layer 112B can encapsulate the regions between first die layer 102 and second die layer 104 that are not occupied by conductive bonding structures 112A. Similarly, underfill layer 114B can encapsulate the regions between second die layer 104 and package substrate 106 that are not occupied by conductive bonding structures 114A.

In some embodiments, package substrate 106 can be a laminate substrate (coreless) or can have cores (not shown). Package substrate 106 can include conductive lines 106A and conductive vias 106B that are electrically connected to conductive bonding structures 114A. In some embodiments, conductive lines 106A and conductive vias 106B can include Cu, titanium (Ti), tungsten (W), aluminum (Al), a metal alloy (such as a Cu alloy and an Al alloy), or any other suitable conductive material. In some embodiments, package substrate 106 can be disposed on and electrically connected to a circuit board (not shown) with bonding structures 120A (e.g., solder bumps) and can electrically connect 3DIC die package 100 to external devices through the circuit board.

In some embodiments, RDL 108 can include conductive lines 108A and conductive vias 108B disposed in a dielectric layer 108C. RDL 108 can be configured to fan out the electrical connections of first die layer 102. In some embodiments, RDL 108 can be electrically bonded to overlying die layers (not shown) with bonding structures 120A, which can include solder bumps. Similarly, RDL 110 can include conductive lines 110A and conductive vias 110B disposed in a dielectric layer 110C. RDL 110 can be configured to fan out the electrical connections of second die layer 104. In some embodiments, RDL 108 can be directly bonded to first die layer 102 without bonding layer 112. In some embodiments, conductive lines 108A and 110A and conductive vias 108B and 110B can include Cu, Ti, W, Al, a metal alloy (such as a Cu alloy and an Al alloy), or any other suitable conductive material.

In some embodiments, first die layer 102 can include (i) a first IC die 102A, (ii) conductive through-vias 102B, and (iii) an encapsulation layer 102C. IC die also referred to as "active die" or "functional die." In some embodiments, first IC die 102A can include a high-performance IC die, such as a SoC die, a micro control unit (MCU) die, a microprocessor unit (MPU) die, an accelerated processing unit (APU) die, a central processing unit (CPU) die, a graphics processing unit (GPU) die, and a combination thereof. Though a single IC die 102A is shown in first die layer 102, any number of IC dies can be included in first die layer 102.

In some embodiments, first IC die 102A can further include a contact layer 122. Contact layer 122 can be disposed on active devices (not shown) in first IC die 102A and can electrically connect first IC die 102A to second die layer 104 through bonding layer 112 and/or RDL 110. In some embodiments, contact layer 122 can include metal pads 122A and 122B and passivation layers 122C and 122D. In some embodiments, metal pads 122A can include Al and can be electrically connected to interconnect metal lines (not shown) of first IC die 102A. In some embodiments, metal pads 122B can include Cu and can be disposed directly on metal pads 122A. Metal pads 122B can be electrically bonded (e.g., solder bonded or Cu bonded) to conductive bonding structures 112A. In some embodiments, metal pads 122B can be in direct contact with conductive vias 110B of RDL 110 in the absence of bonding layer 112. Adjacent metal pads 122A can be electrically insulated from each other by passivation layer 122C, and adjacent metal pads 122B can be electrically insulated from each other by passivation layers 122C and 122D. In some embodiments, passivation layer 122C can include an insulating oxide layer and passivation layer 122D can include an insulating nitride layer.

In some embodiments, conductive through-vias 102B can include can include Cu, Ti, W, Al, a metal alloy (such as a Cu alloy and an Al alloy), or any other suitable conductive material. Conductive through-vias 102B can be electrically bonded (e.g., solder bonded or Cu bonded) to conductive bonding structures 112A and can be directly and electrically connected to conductive vias 108B of RDL 108. In some embodiments, conductive through-vias 102B can be directly connected to conductive vias 110B of RDL 110 in the absence of bonding layer 112. Conductive through-vias 102B can be configured to provide electrical connections between first IC die 102A and (i) second die layer 104 through bonding layer 112 and RDL 110, (ii) package substrate 106 through second die layer 104, bonding layers 112 and 114, and RDL 110, and/or (iii) overlying die layers (not shown) through RDL 108. First IC die 102A and conductive through-vias 102B can be surrounded by encapsulation layer 102C, including a molding compound, an epoxy, a resin, or any other suitable encapsulation material.

In some embodiments, second die layer 104 can include (i) a second IC die 104A, (ii) conductive through-vias 104B, and (iii) an encapsulation layer 104C. In some embodiments, second IC die 104A can include a logic die or a memory die. In some embodiments, conductive through-vias 104B can include can include Cu, Ti, W, Al, a metal alloy (such as a Cu alloy and an Al alloy), or any other suitable conductive material. Conductive through-vias 104B can be electrically bonded (e.g., solder bonded or Cu bonded) to conductive bonding structures 114A and can be in direct contact with conductive vias 110B of RDL 110. Conductive through-vias 104B can be configured to provide electrical connections between second IC die 104A and (i) components of first die layer 102 through bonding layer 112 and RDL 110, (ii) package substrate 106 through bonding layer 114, and/or (iii) die layers (not shown) over first die layer 102 through RDLs 108 and 110, bonding layer 112, and conductive through-vias 102B. Second IC die 104A and conductive through-vias 104B can be surrounded by encapsulation layer 104C, including a molding compound, an epoxy, a resin, or any other suitable encapsulation material.

In some embodiments, second IC die 104A can include (i) a substrate 124, (ii) semiconductor devices 126, (iii) trench capacitors 128, (iv) interconnect structures 130A and 130B, (v) contact layers 132A and 132B, and (vi) conductive through-vias 136. Second IC die 104A can include any number of semiconductor devices 126, trench capacitors 128, and conductive through-vias 136. Though a single IC die 104A is shown in second die layer 104, additional IC dies similar to second IC die 104A or other type of IC dies without trench capacitors 128 can be included in second die layer 104. And, though second IC die 104A is shown to be electrically connected to a single IC die 102A, second IC die 104A can be electrically connected to any number of IC dies similar to or different from first IC die 102A.

In some embodiments, substrate 124 can include a semiconductor material, such as silicon, silicon germanium, and any suitable semiconductor material. Semiconductor devices 126 (e.g., transistors) can be formed on a first surface 124a (also referred to as "front-side surface 124a") of substrate 124 and trench capacitors 126 can be formed on a second surface 124b (also referred to as "back-side surface 124b") of substrate 124. In some embodiments, semiconductor devices 126 can be aligned or misaligned with trench capacitors, as shown in Fig. 1A. Interconnect structure 130A can be disposed on and electrically connected to semiconductor devices 126, and contact layer 132A can be disposed directly on and electrically connected to interconnect structure 130A. Similarly, interconnect structure 130B can be disposed on and electrically connected to trench capacitors 128, and contact layer 132B can be disposed directly on and electrically connected to interconnect structure 130B. Semiconductor devices 126 can be electrically connected to conductive bonding structures 114A through interconnect structure 130A and contact layer 132A. Similarly, trench capacitors 128 can be electrically connected to RDL 110 through interconnect structure 130B and contact layer 132B.

Interconnect structures 130A and 130B can include several levels of horizontal metal lines and vertical metal vias. Each of contact layers 130A and 130B can include (i) metal pads 134A and 134B similar to metal pads 122A and 122B, respectively, and (ii) passivation layers 134C and 134D similar to passivation layers 122C and 122D, respectively. In some embodiments, metal pads 134A can be disposed directly on the metal vias in the topmost levels of interconnect structures 132A and 132B, and metal pads 134B can be disposed directly on metal pads 134A. Metal pads 134B of contact layer 132A can be electrically bonded (e.g., solder bonded or Cu bonded) to conductive bonding structures 114A, and metal pads 134B of contact layer 132B can be electrically connected to RDL 110. In some embodiments, conductive through-vias 136-including Cu, Ti, W, Al, a metal alloy (such as a Cu alloy and an Al alloy), or any other suitable conductive material-can be disposed in substrate 124. Conductive through-vias 136 can provide electrical connections between interconnect structures 130A and 130B and between trench capacitors 128 and semiconductor devices 126. The different electrical connections shown in 3DIC die package 100 with conductive through-vias 102B, 104B, and 136, RDLs 108 and 110, bonding layers 112 and 114, interconnect structures 130A and 130B, and package substrate 106 are exemplary and not limiting.

Trench capacitors 128 can function as decoupling capacitors and reduce power supply noise in first and second IC dies 102A and 104A. As discussed above, higher capacitance density can be achieved with trench capacitors, such as trench capacitors 128, compared to MIM capacitors formed in interconnect structures. And, die package size can be reduced by integrating trench capacitors 128 in IC dies, such as second IC die 104A, instead of in passive interposers. Thus, with the use of trench capacitors 128 in second IC die 104A, performance of first and second IC dies 102A and 104A can be improved without compromising the size of 3DIC die package.

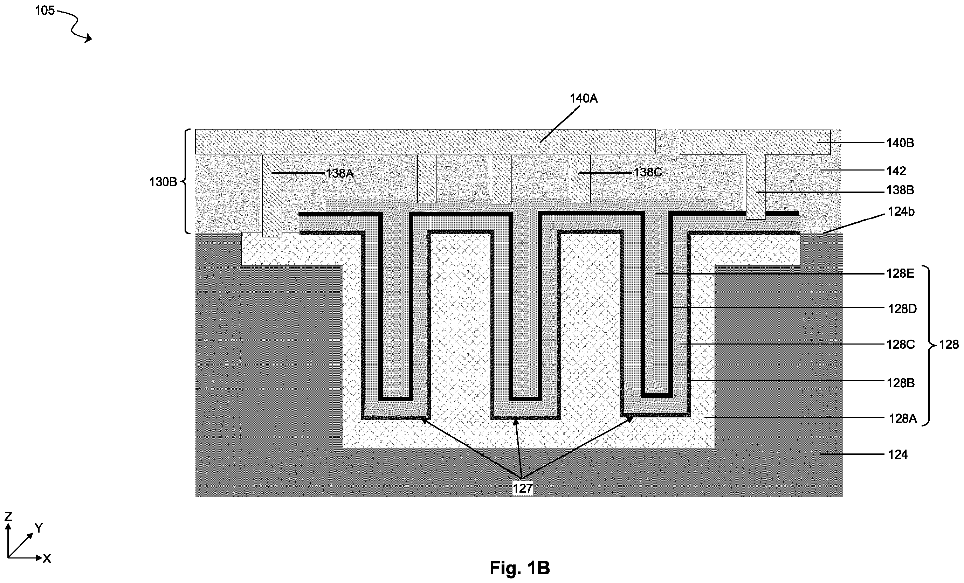

One of trench capacitors 128 is described with reference to Fig. 1B, which is an enlarged cross-sectional view of region 105 of Fig. 1A. In some embodiments, trench capacitor 128 can include (i) a doped conductive region 128A disposed in substrate 124 and surrounding trenches 127 formed in substrate 124 through second surface 124b, (ii) a high-k dielectric layer 128B disposed on second surface 124b and on sidewalls of trenches 127, (iii) a conductive layer 128C disposed directly on high-k dielectric layer 128B, (iv) a high-k dielectric layer 128D disposed directly on conductive layer 128C, and (v) a conductive layer 128E disposed directly on high-k dielectric layer 128D. In some embodiments, doped conductive region 128A can include dopants of a conductivity type (e.g., p-type) opposite to that in substrate 124. Doped conductive region 128A can include a dopant concentration higher (e.g., about 1 to about 2 orders higher) than a dopant concentration in substrate 124. In some embodiments, conductive layers 128C and 128E can include a conductive material, such as polysilicon or a metallic material. In some embodiments, high-k dielectric layers 128B and 128D can include a high-k dielectric material, such as hafnium oxide (HfO₂), titanium oxide (TiO₂), aluminum oxide (Al₂O₃), and other suitable high-k dielectric materials.

Doped conductive region 128A and conductive layers 128C and 128E can be electrically coupled to power sources through contact structures 138A, 138B, and 138C, respectively, of interconnect structure 130B. Contact structures 138A can be disposed directly on doped conductive region 128A, contact structure 138B can be disposed directly on conductive layer 128C, and contact structures 138C can be disposed directly on conductive layer 128E. In some embodiments, contact structures 138A, 138B, and 138C can include a conductive material, such as Al, Cu, W, and other suitable conductive materials. Contact structures 138A and 138C can be electrically connected to a first power source (not shown) through metal line 140A of interconnect structure 130B to provide a first voltage V1 to doped conductive region 128A and conductive layer 128E. On the other hand, contact structure 138B can be electrically connected to a second power source (not shown) through metal line 140B of interconnect structure 130B to provide a second voltage V2 to conductive layer 128C that is higher or lower than first voltage V1.

Such electrical configuration between doped conductive region 128A and conductive layers 128C and 128E can form trench capacitors C1 and C2 connected in parallel. Doped conductive region 128A and conductive layer 128C can form the parallel plates of capacitor C1, which are separated by high-k dielectric layer 128B. Conductive layers 128C and 128E can form the parallel plates of capacitor C2, which are separated by high-k dielectric layer 128D. Capacitor C1 and capacitor C2 share conductive layer 128C as a common plate. Thus, trench capacitor 128 can have capacitors C1 and C2 disposed in a stacked configuration in trenches 127 and connected in parallel to each other. Though trench capacitor 128 is shown to have two capacitors C1 and C2, trench capacitor 128 can have any number of capacitors formed in trenches 127 in a stacked configuration and connected in parallel to each other. In some embodiments, interconnect structure 130B can further include dielectric layer 142 having silicon oxide, silicon oxycarbide (SiOC), nitrogen doped silicon carbide (SiCN), silicon oxycarbon nitride (SiCON), or oxygen doped silicon carbide.

Referring to Fig. 1A, IPD 118 can include resistors, inductors, and/or decoupling capacitors similar to trench capacitor 128 and can be electrically connected to package substrate 106 with a bonding layer 116. Similar to bonding layer 114, bonding layer 116 includes conductive bonding structures 116A and underfill layer 116B. With the integration of trench capacitors 128 in IC dies (e.g., second IC die 104A), the number of IPDs (e.g., IPD 118) in 3DIC die packages (e.g., 3DIC die package 100) can be reduced. By reducing the number of IPDs, more space can be available on package substrate 106 for adding routing elements, such as bonding structures 120A to increase electrical connections of 3DIC die package 100 with external devices.

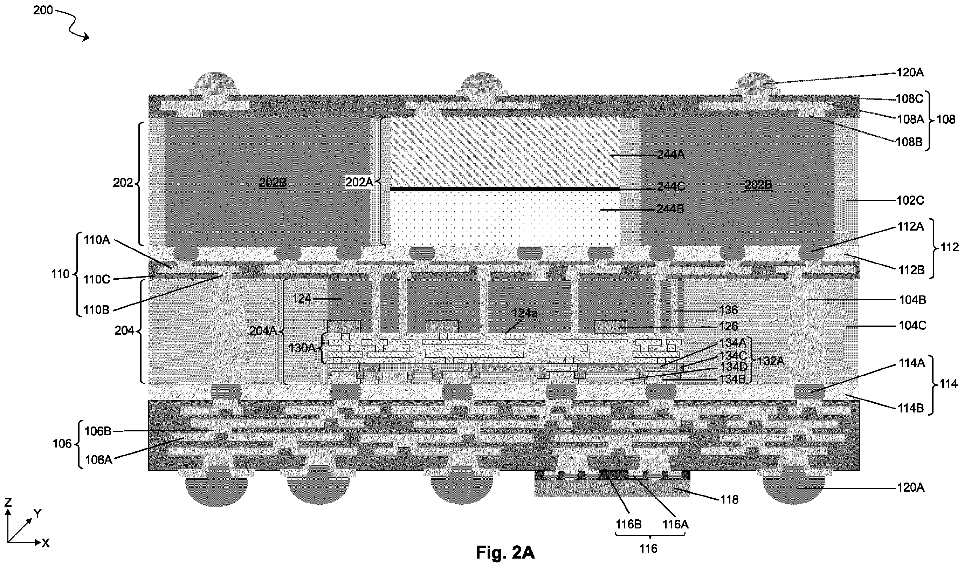

Fig. 2A illustrates a cross-sectional view of a 3DIC die package 200, according to some embodiments. The discussion of elements in Figs. 1A and 2A with the same annotations applies to each other, unless mentioned otherwise. In some embodiments, 3DIC die package 200 can include (i) a first die layer 202, (ii) a second die layer 204, (iii) a package substrate 106, (iv) redistribution layers (RDLs) 108 and 110, (v) bonding layers 112, 114, and 116, (vi) IPD 118, and (vii) conductive bonding structures 120A and 120B. First die layer 202 can be disposed on second die layer 204, which can be disposed on package substrate 106. In some embodiments, first die layer 202 can be electrically bonded to underlying second die layer 204 with redistribution layer 110 and bonding layer 112. Similarly, in some embodiments, second die layer 204 can be electrically bonded to underlying package substrate 106 with bonding layer 114. In some embodiments, first die layer 202 can be electrically bonded to overlying die layers (not shown) with redistribution layer 108.

In some embodiments, first die layer 202 can include (i) a hybrid die 202A, (ii) memory dies 202B, and (iii) an encapsulation layer 102C. In some embodiments, hybrid IC die 202A can include an active die 244A and a passive die 244B, which are hybrid bonded at a hybrid bond interface 244C. In some embodiments, active die 244A can include a logic die, a memory die, or a high-performance IC die (e.g., a SoC die, a micro control unit (MCU) die, a microprocessor unit (MPU) die, an accelerated processing unit (APU) die, a central processing unit (CPU) die, a graphics processing unit (GPU) die, and a combination thereof). Hybrid die 202A and memory dies 202B can be surrounded by encapsulation layer 102C. Though a single hybrid die 202A is shown in first die layer 202, any number of hybrid dies similar to hybrid die 202A can be included in first die layer 202. And, first die layer 202 can include any number of memory dies 202B. In some embodiments, hybrid die 202A and memory dies 202B can be electrically connected to elements of second die layer 204 and/or to package substrate 106 through bonding structures 112A and RDL 110. In some embodiments, hybrid die 202A and memory dies 202B can be electrically connected to overlying dies (not shown) through RDL 108.

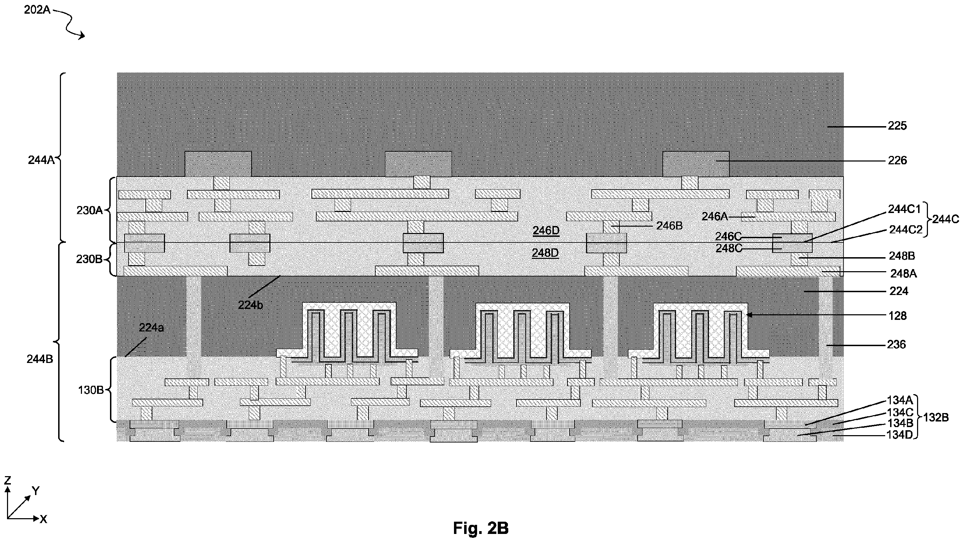

Hybrid die 202A is further described with reference to Fig. 2B, which is an enlarged cross-sectional view of hybrid die 202A. Fig. 2B shows hybrid die 202A with additional elements that are not shown in Fig. 2A for simplicity. The discussion of elements in Figs. 1A, 1B, 2A, and 2B with the same annotations applies to each other, unless mentioned otherwise. Referring to Fig. 2B, in some embodiments, active die 244A can include (i) a substrate 225, (ii) semiconductor devices 226, and (iii) interconnect structure 230A. Substrate 225 can include semiconductor material, and semiconductor devices 226 can include transistors. Interconnect structure 230A can include metal lines 246A, metal vias 246B, and metal bonding pads 246C disposed in a dielectric layer 246D. In some embodiments, metal lines 246A, metal vias 246B, and metal bonding pads 246C can include a conductive material, such as Cu, Al, W, or any other suitable conductive material. In some embodiments, dielectric layer 246D can include silicon oxide (SiO₂), silicon nitride (SiN), silicon carbide (SiC), silicon oxynitride (SiON), silicon carbon nitride (SiCN), or any other suitable dielectric material. In some embodiments, active die 244A can include additional routing elements (not shown), such as conductive through-vias and contact structures that can electrically connect active die 244A to RDL 108.

In some embodiments, passive die 244B can include (i) a substrate 224, (ii) trench capacitors 128, (iii) interconnect structures 130B and 230B, (iv) contact layer 132B, and (v) conductive through-vias 236. The discussion of substrate 124 applies to substrate 224, unless mentioned otherwise. Trench capacitors 128 can be formed through first surface 224a of substrate 224, and interconnect structure 230B can be disposed on second surface 224b of substrate 224. In some embodiments, conductive through-vias 236-including Cu, Ti, W, Al, a metal alloy (such as a Cu alloy and an Al alloy), or any other suitable conductive material-can be disposed in substrate 324. Conductive through-vias 236 can provide electrical connections between interconnect structures 130B and 230B. Similar to interconnect structure 230A, interconnect structure 230B can include metal lines 248A, metal vias 248B, and metal bonding pads 248C disposed in a dielectric layer 248D. Metal lines 246A, metal vias 246B, metal bonding pads 246C, and dielectric layer 248D can include materials similar to metal lines 246A, metal vias 246B, metal bonding pads 246C, and dielectric layer 246D, respectively. In some embodiments, metal pads 134B of contact layer 132B can be electrically connected to conductive bonding structures 112A.

Hybrid die 202A further includes metal-to-metal bonds 244C1 ("metal bonds 244C1") formed between metal bonding pads 246C and 248C and dielectric-to-dielectric bonds 244C2 ("dielectric bonds 244C2") formed between dielectric layers 246D and 248D. Metal bonds 244C1 and dielectric bonds 244C2 are formed at hybrid bond interface 244C between active die 244A and passive die 244B. Electrical connections between the elements of active die 244A and passive die 244B can be made through metal bonds 244C1. Thus, with the use of hybrid bonding, trench capacitors 128 can be integrated with active dies, such as active die 244A to reduce or minimize any power supply noise and/or unwanted parasitic effects in 3DIC package 200.

Referring to Fig. 2A, second die layer 204 can include (i) IC die 204A, (ii) conductive through-vias 104B, and (iii) encapsulation layer 104C. In some embodiments, IC die 204A can include a logic die or a memory die. Conductive through-vias 104B can be configured to provide electrical connections between IC die 204A and (i) components of first die layer 202 through bonding layer 112 and RDL 110, (ii) package substrate 106 through bonding layer 114, and/or (iii) die layers (not shown) overlying first die layer 202 through RDLs 108 and 110 and bonding layer 112. IC die 204A and conductive through-vias 104B can be surrounded by encapsulation layer 104C. In some embodiments, IC die 204A can include (i) substrate 124, (ii) semiconductor devices 126, (iii) interconnect structure 130A, (v) contact layer 132A, and (vi) conductive through-vias 136. IC die 204A can include any number of semiconductor devices 126 and conductive through-vias 136 and IC die 204A can be electrically connected to any number of hybrid die 202A and memory dies 202B. Though a single IC die 204A is shown in second die layer 204, additional IC dies similar to IC die 204A can be included in second die layer 204.

The different electrical connections shown in 3DIC die package 200 with conductive through-vias 104B, 136, and 236, RDLs 108 and 110, bonding layers 112 and 114, interconnect structures 130A, 130B, 230A, and 230B, and package substrate 106 are exemplary and not limiting.

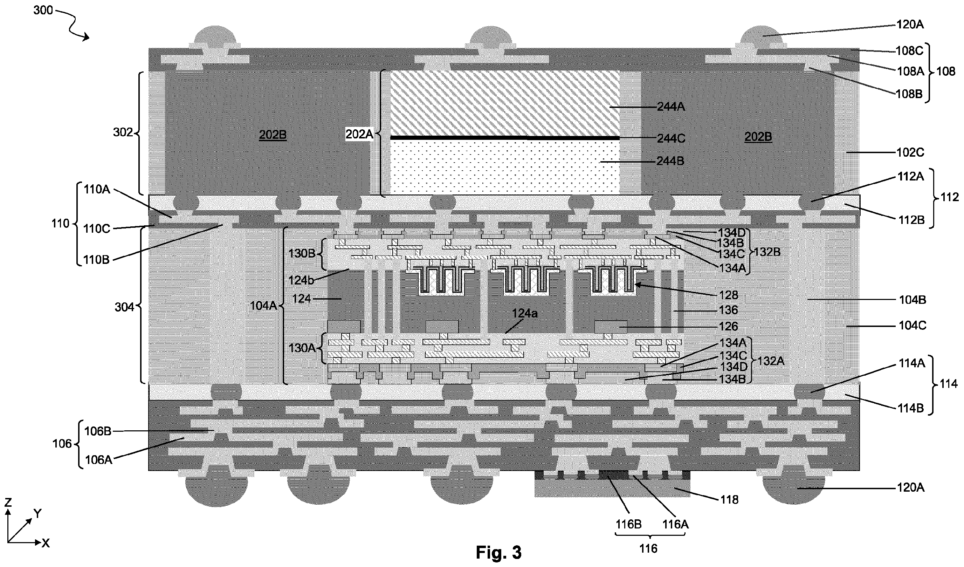

Fig. 3 illustrates a cross-sectional view of a 3DIC die package 300, according to some embodiments. The discussion of elements in Figs. 1A, 1B, 2A, and 2B with the same annotations applies to each other, unless mentioned otherwise. In some embodiments, 3DIC die package 300 can include (i) a first die layer 302, (ii) a second die layer 304, (iii) a package substrate 106, (iv) redistribution layers (RDLs) 108 and 110, (v) bonding layers 112, 114, and 116, (vi) IPD 118, and (vii) conductive bonding structures 120A and 120B. The discussion of first and second die layers 202 and 204 applies to first and second die layers 302 and 304, respectively, unless mentioned otherwise. Unlike second die layer 204, second die layer 304 can include second IC die 104A, as described with reference to Figs. 1A and 1B. Thus, in some embodiments, 3DIC package 300 can include trench capacitors 128 integrated with different active dies (e.g., IC dies 104A and 202A) vertically stacked in 3DIC package 300.

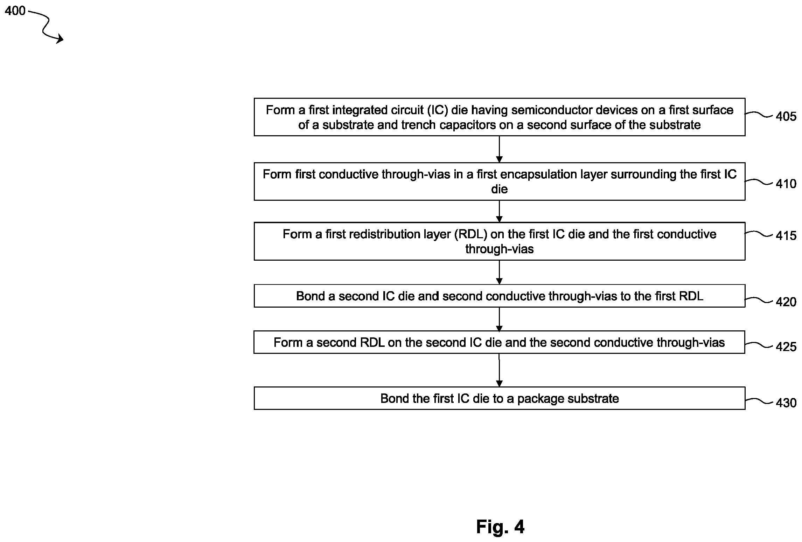

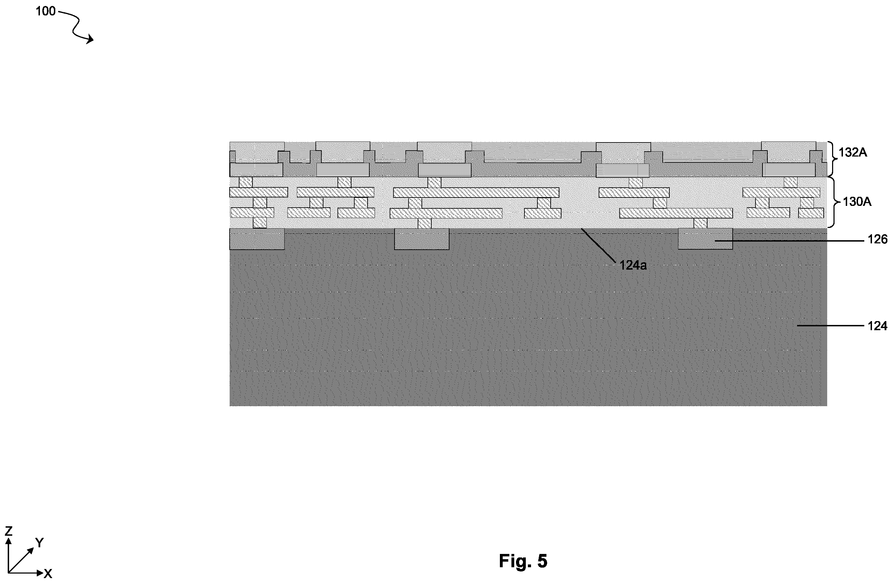

Fig. 4 is a flow diagram of an example method 400 for fabricating 3DIC die package 100 shown in Figs. 1A and 1B, according to some embodiments. For illustrative purposes, the operations illustrated in Fig. 4 will be described with reference to the example fabrication process for fabricating 3DIC die package 100 as illustrated in Figs. 5-12. Figs. 5-12 are cross-sectional views of 3DIC die package 100 at various stages of fabrication, according to some embodiments. Operations can be performed in a different order or not performed depending on specific applications. It should be noted that method 400 may not produce a complete 3DIC die package 100. Accordingly, it is understood that additional processes can be provided before, during, and after method 400, and that some other processes may only be briefly described herein. Elements in Figs. 5-12 with the same annotations as elements in Figs. 1A and 1B are described above.

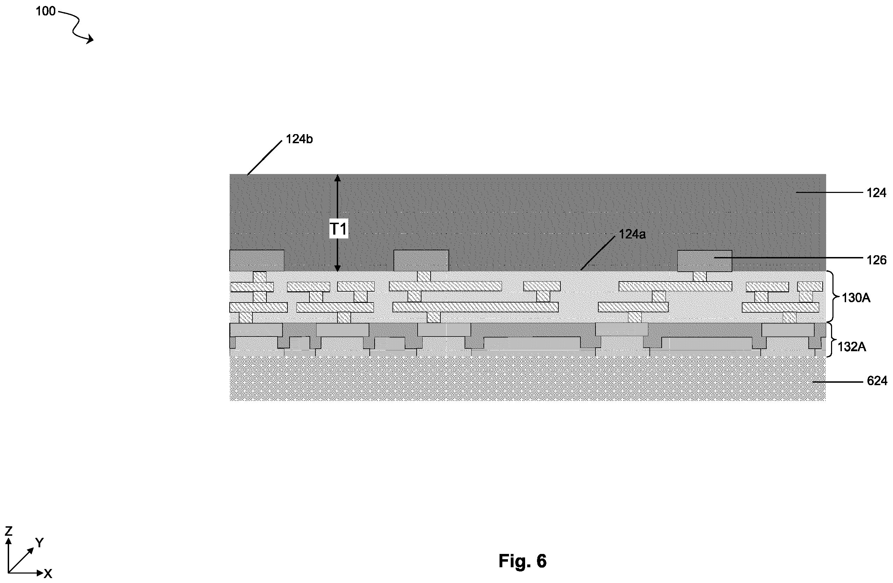

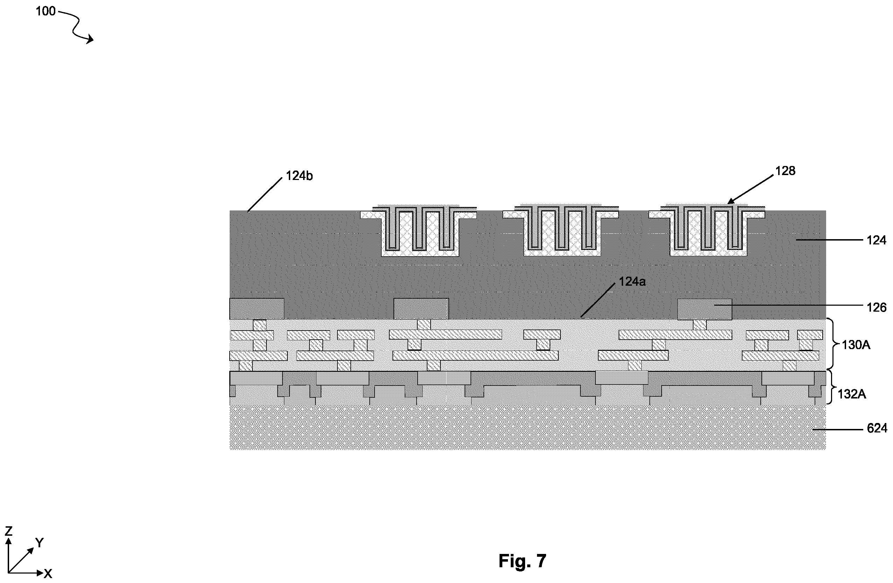

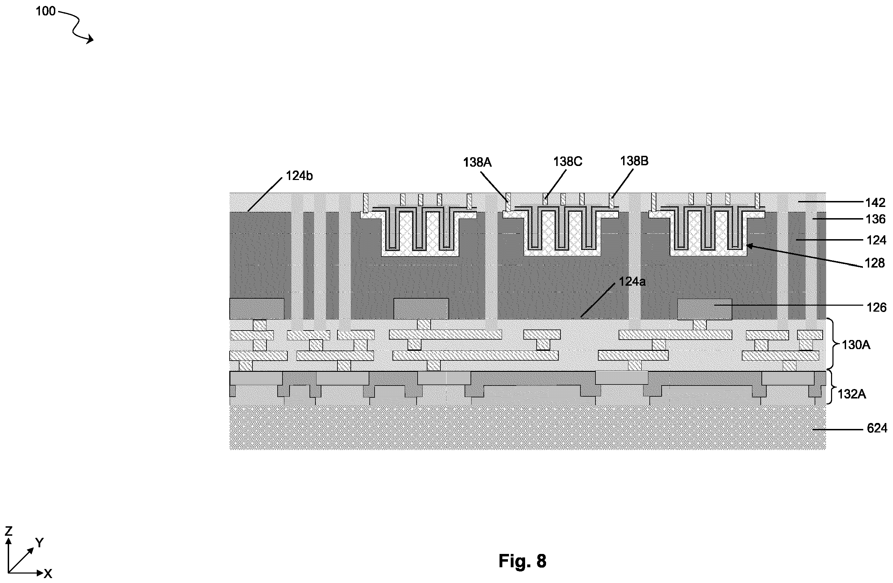

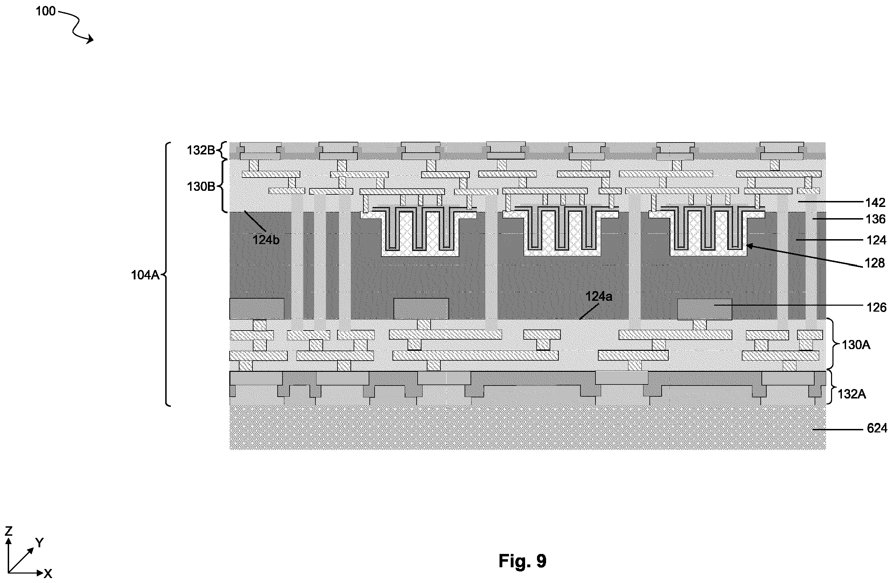

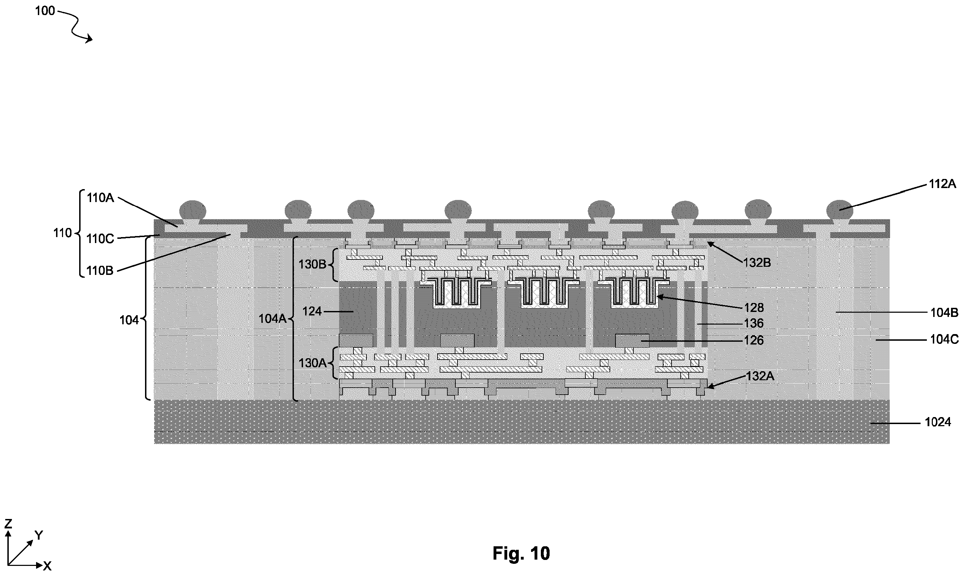

Referring to Fig. 4, in operation 405, a first IC die having semiconductor devices on a first surface of a substrate and trench capacitors on a second surface of the substrate is formed. For example, as described with reference to Figs. 5-9, IC die 104A having semiconductor devices 126 on first surface 124a of substrate 124 and trench capacitors 128 on second surface 124b of substrate 124 is formed. The formation of IC die 104A can include sequential operations of (i) forming semiconductor devices 126 on first surface 124a, as shown in Fig. 5, (ii) forming interconnect structure 130A on semiconductor devices 126, as shown in Fig. 5, (iii) forming contact layer 132A on interconnect structure 130A, as shown in Fig. 5, (iv) bonding the structure of Fig. 5 on a carrier substrate 624, as shown in Fig. 6, (v) thinning substrate 124 to a thickness T1 of about 200 µm to about 300 µm, as shown in Fig. 6, (vi) forming trench capacitors 128 in substrate 124 through second surface 124b, as shown in Fig. 7, (vii) forming contact structures 138A, 138B, and 138C on trench capacitors 128, as shown in Fig. 8, (viii) forming conductive through-vias 136 in substrate 124, as shown in Fig. 8, (ix) forming metal lines and metal vias of interconnect structure 130B on contact structures 138A, 138B, and 138C and conductive through-vias 136, as shown in Fig. 9, and (x) forming contact layer 132B on interconnect structure 130B, as shown in Fig. 9. In some embodiments, the formation of IC die 104A can be followed by the removal of carrier substrate 624, bonding of IC die 104A to a carrier substrate 1024 longer than carrier substrate 624, as shown in Fig. 10 and forming encapsulation layer 104C surrounding IC die 104A, as shown in Fig. 10.

Referring to Fig. 4, in operation 410, first conductive through-vias are formed in a first encapsulation layer surrounding the first IC die. For example, as shown in Fig. 10, conductive through-vias 104B are formed in encapsulation layer 104C. In some embodiments, the formation of conductive through-vias 104B can include sequential operations of (i) forming openings (not shown) in encapsulation layer 104C using a lithographic process, (ii) depositing the material of conductive through-vias 104B in the openings, and (iii) performing a chemical mechanical polishing (CMP) process on the deposited material to substantially coplanarize top surfaces of conductive through-vias 104B and encapsulation layer 104C, as shown in Fig. 10.

Referring to Fig. 4, in operation 415, a first RDL is formed on the first IC die and the first conductive through-vias. For example, as shown in Fig. 10, RDL 110 is formed on conductive through-vias 104B and encapsulation layer 104C. In some embodiments, conductive bonding structures 112A can be formed after the formation of RDL 110.

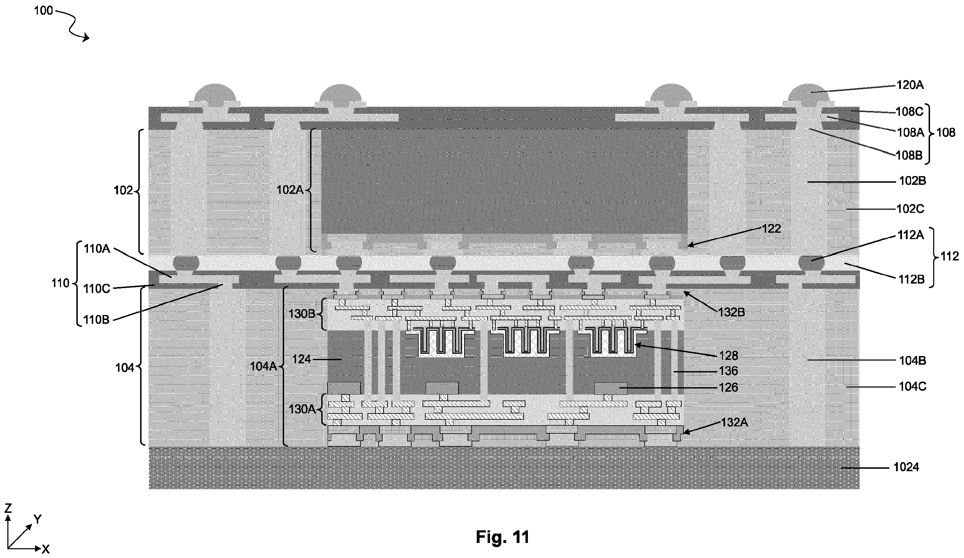

Referring to Fig. 4, in operation 420, a second IC die and second conductive through-vias are bonded to the first RDL. For example, as shown in Fig. 11, IC die 102A and conductive through-vias 102B are bonded to RDL 110 with conductive bonding structures 112A. The bonding of IC die 102A and conductive through-vias 102B to conductive bonding structures 112A can be followed by the formation of underfill layer 112B. In some embodiments, IC die 102A and conductive through-vias 102B can be directly bonded to RDL 110. In some embodiments, prior to bonding IC die 102A and conductive through-vias 102B to RDL 110, the structure of first die layer 102-including IC die 102A, conductive through-vias 102B, and encapsulation layer 102C-can be formed on a carrier substrate (not shown), which can be removed after bonding IC die 102A and conductive through-vias 102B to RDL 110.

Referring to Fig. 4, in operation 425, a second RDL is formed on the second IC die and the second conductive through-vias. For example, as shown in Fig. 11, RDL 108 is formed on IC die 102A and conductive through-vias 102B.

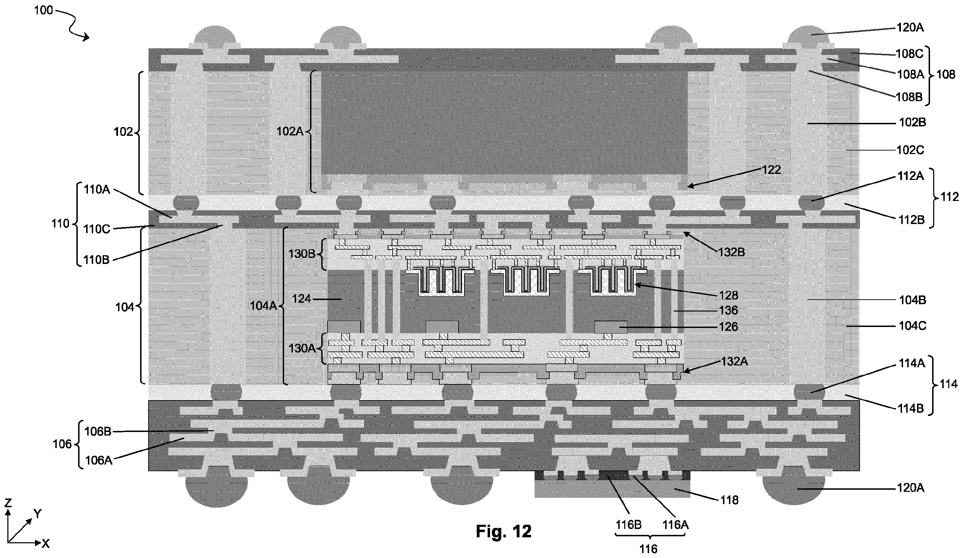

Referring to Fig. 4, in operation 430, the first IC die is bonded to a package substrate. For example, as shown in Fig. 12, IC die 104A is bonded to package substrate 106 with conductive bonding structures 114A. The bonding of IC die 104A to conductive bonding structures 114A can be followed by the formation of underfill layer 114B. In some embodiments, IPD 118 can be bonded to package substrate 106 before or after the bonding of IC die 104A to package substrate 106.

Method 400 can be further used to form 3DIC die packages with different stacking configurations of IC dies, as described below.

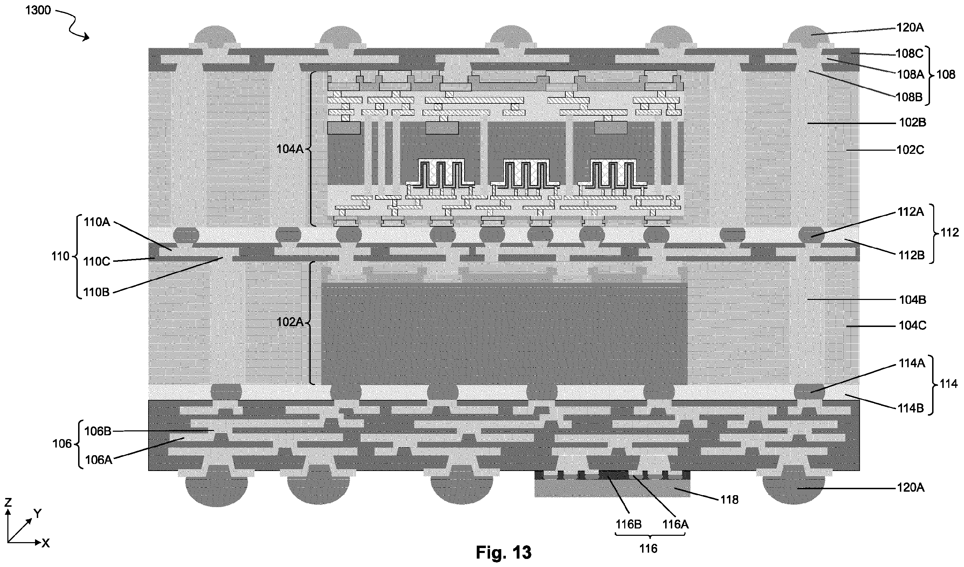

In some embodiments, instead of stacking IC die 102A on IC die 104A in 3DIC die package 100, as shown in Fig. 12, IC die 104A can be stacked on IC die 102A in a 3DIC die package 1300, as shown in Fig. 13.

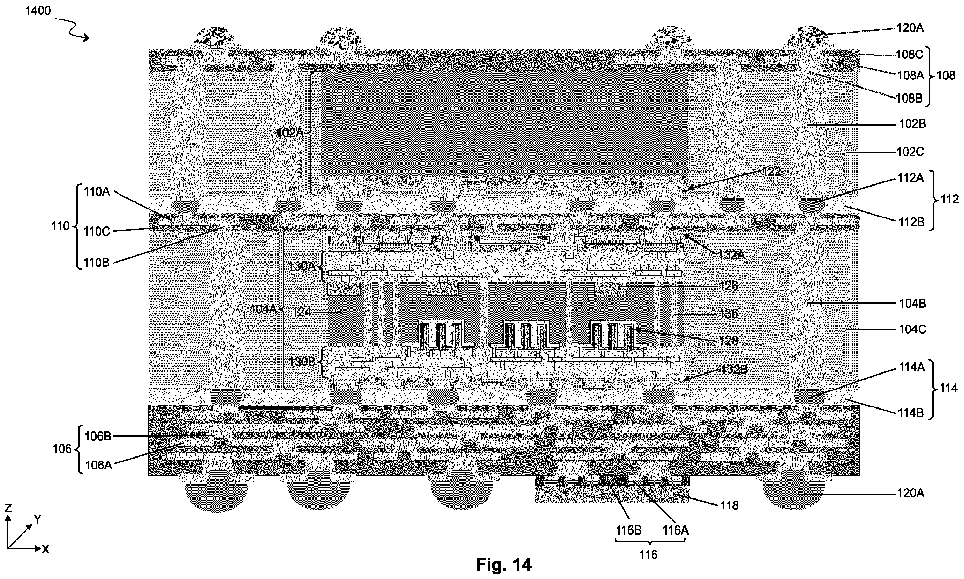

In some embodiments, instead of bonding the trench capacitor side of IC die 104A to RDL 110 in 3DIC die package 100, as shown in Fig. 12, the semiconductor device side of IC die 104A can be bonded to RDL 110 in a 3DIC die package 1400, as shown in Fig. 14.

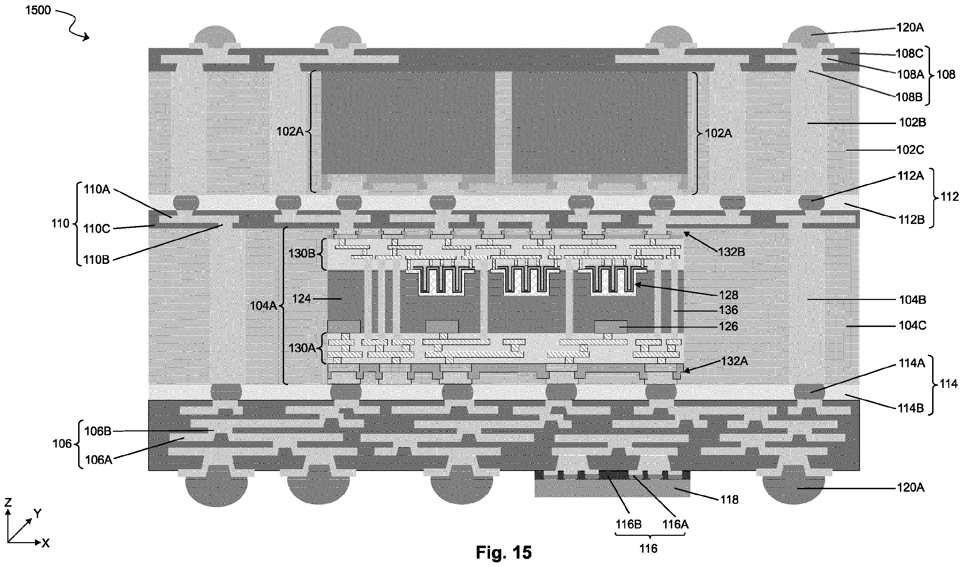

In some embodiments, instead of electrically bonding a single IC die 102A to IC die 104A in 3DIC die package 100, as shown in Fig. 12, two IC dies 102A can be electrically bonded to IC die 104A in a 3DIC die package 1500, as shown in Fig. 15.

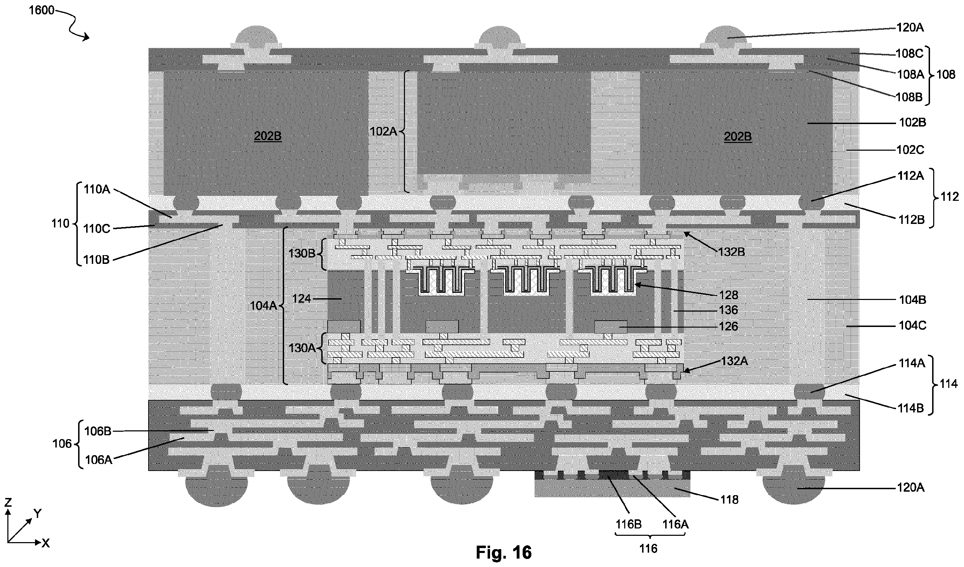

In some embodiments, instead of electrically bonding a single IC die 102A to IC die 104A in 3DIC die package 100, as shown in Fig. 12, different types of IC dies, such as IC die 102A and memory dies 202B can be electrically bonded to IC die 104A in a 3DIC die package 1600, as shown in Fig. 16.

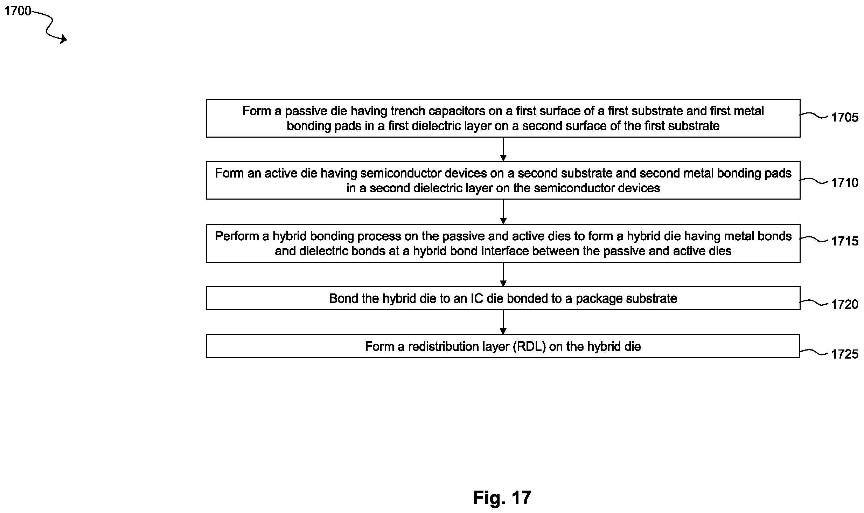

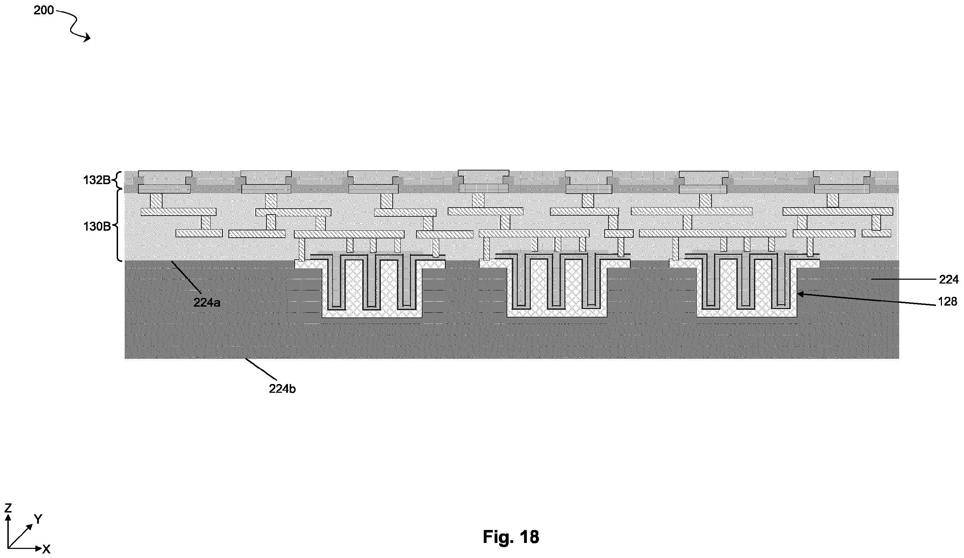

Fig. 17 is a flow diagram of an example method 1700 for fabricating 3DIC die package 200 shown in Figs. 2A and 2B, according to some embodiments. For illustrative purposes, the operations illustrated in Fig. 17 will be described with reference to the example fabrication process for fabricating 3DIC die package 100 as illustrated in Figs. 18-22. Figs. 18-22 are cross-sectional views of 3DIC die package 200 at various stages of fabrication, according to some embodiments. Operations can be performed in a different order or not performed depending on specific applications. It should be noted that method 1700 may not produce a complete 3DIC die package 200. Accordingly, it is understood that additional processes can be provided before, during, and after method 1700, and that some other processes may only be briefly described herein. Elements in Figs. 18-22 with the same annotations as elements in Figs. 1A, 1B, 2A, and 2B are described above.

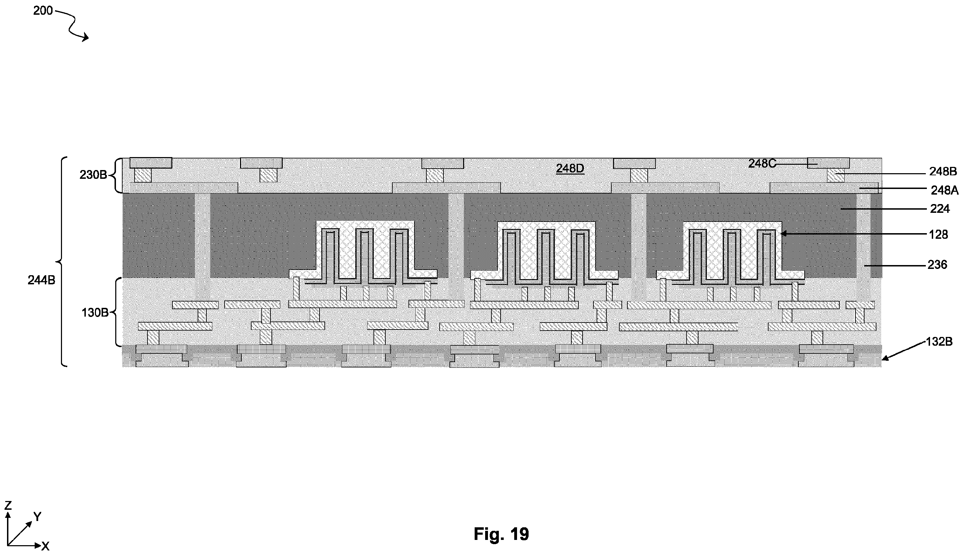

Referring to Fig. 17, in operation 1705, a passive die having trench capacitors on a first surface of a first substrate and first metal bonding pads in a first dielectric layer on a second surface of the first substrate is formed. For example, as described with reference to Figs. 18 and 19, passive die 244B having trench capacitors 128 on first surface 224a of substrate 224 and metal bonding pads 248C in dielectric layer 248D on second surface 224b of substrate 224 is formed. The formation of passive die 224B can include sequential operations of (i) forming trench capacitors 128 in substrate 124 through first surface 224a, as shown in Fig. 18, (ii) interconnect structure 130B trench capacitors 128, as shown in Fig. 18, (iii) forming contact layer 132B on interconnect structure 130B, as shown in Fig. 18, (iv) forming conductive through-vias 236 in substrate 224, as shown in Fig. 19, and (v) forming interconnect structure 230B on second surface 224b of substrate 224, as shown in Fig. 19.

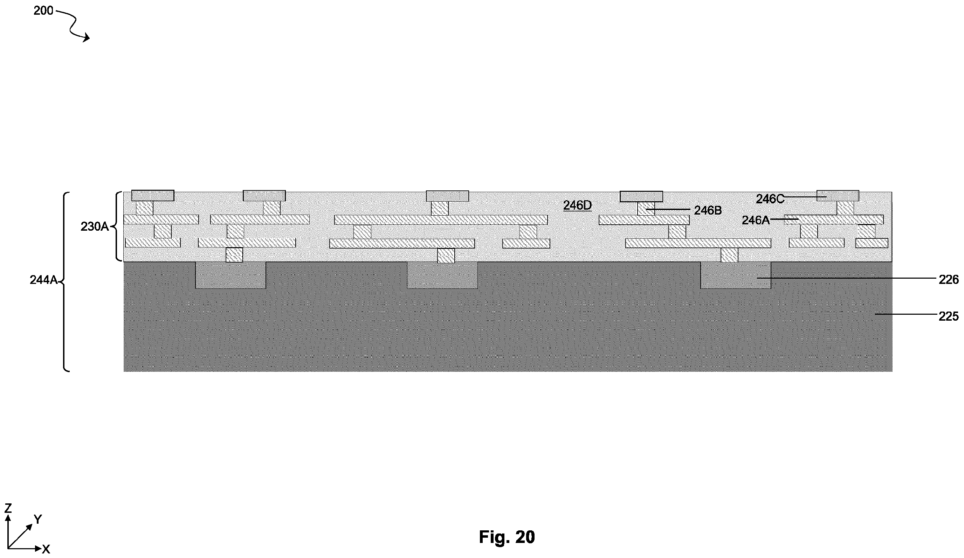

Referring to Fig. 17, in operation 1710, an active die having semiconductor devices on a second substrate and second metal bonding pads in a second dielectric layer on the semiconductor devices is formed. For example, as shown in Fig. 20, active die 244A having semiconductor devices 226 on substrate 225 and metal bonding pads 246C in dielectric layer 246D on the semiconductor devices 226 is formed. The formation of active die 224A can include sequential operations of (i) forming semiconductor devices 226 on substrate 225, as shown in Fig. 20, and (ii) forming interconnect structure 230A on semiconductor devices 226, as shown in Fig. 20.

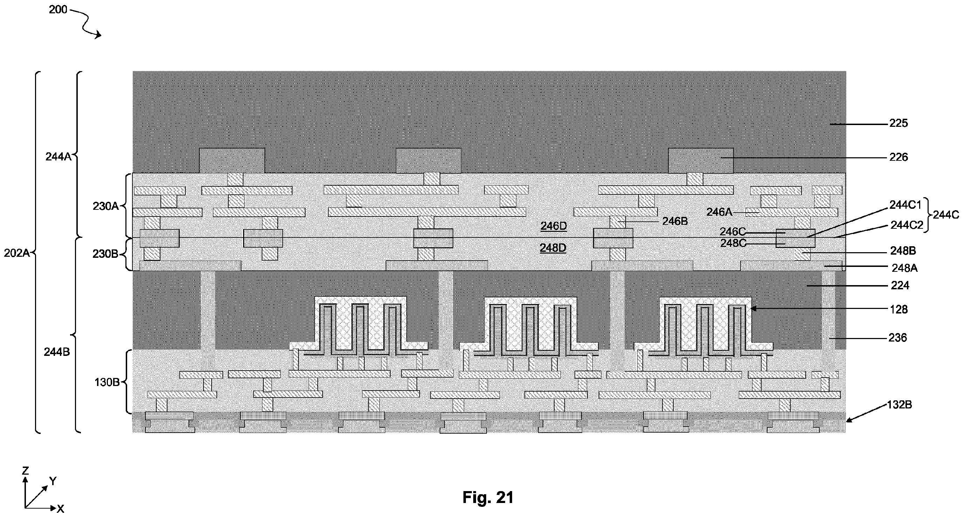

Referring to Fig. 17, in operation 1715, a hybrid bonding process is performed on the passive and active dies to form a hybrid die having metal bonds and dielectric bonds at a hybrid bond interface between the passive and active dies. For example, as described with reference to Fig. 21, hybrid die 202A-including metal bonds 244C1 and dielectric bonds 244C2 at hybrid bond interface 244C-is formed after performing a hybrid bonding process on active die 244A and passive die 244B. In some embodiments, performing the hybrid bonding process can include sequential operations of (i) performing an activation process with a plasma (e.g., hydrogen plasma) on top surfaces of metal bonding pads 246C and 248C and dielectric layers 246D and 248D, (ii) substantially aligning and coupling metal bonding pads 246C to metal bonding pads 248C and dielectric layer 246D to dielectric layer 248D, as shown in Fig. 21, (iii) performing a thermal treatment on the structure of Fig. 21 at a temperature of about 150 °C to about 500 °C. The hybrid bonding process is performed in an oxygen-free environment to prevent oxidation of metal bonding pads 246C and 248C.

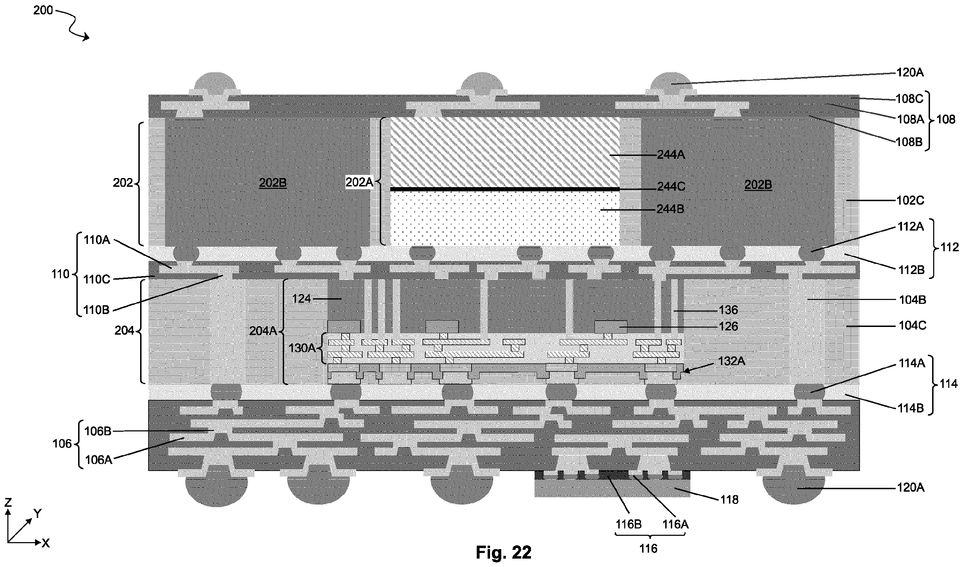

Referring to Fig. 17, in operation 1720, the hybrid die is bonded to an IC die bonded to a package substrate. For example, as shown in Fig. 22, hybrid die 202A is bonded to IC die 204A with conductive bonding structures 112A. In some embodiments, the structure of second die layer 204 can be formed prior to the bonding of hybrid die 202A to IC die 204A. In some embodiments, memory dies 202B can be bonded to conductive bonding structures 112A before or after bonding hybrid die 202A to IC die 204A. In some embodiments, underfill layer 112B can be formed after the bonding of hybrid die 202A to IC die 204A.

Referring to Fig. 17, in operation 1725, an RDL is formed on the hybrid die. For example, as shown in Fig. 22, RDL 108 is formed on hybrid die 202A.

Method 1700 can be further used to form 3DIC die packages with different stacking configurations of hybrid dies, as described below.

In some embodiments, instead of IC die 204A, hybrid die 202A can be bonded to IC die 104A with conductive bonding structures 112A to form the structure of 3DIC die package 300, as shown in Fig. 3.

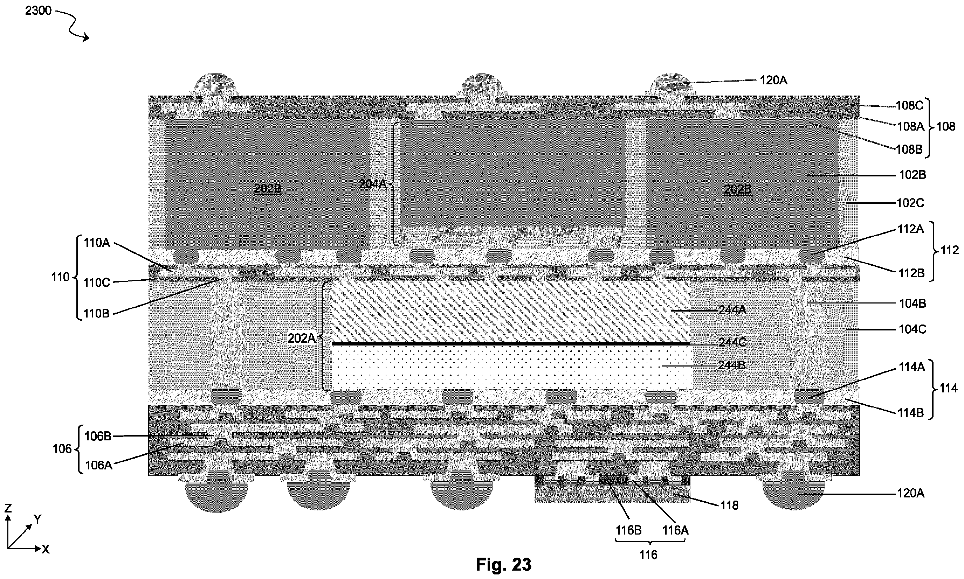

In some embodiments, instead of stacking hybrid die 202A on IC die 204A in 3DIC die package 200, as shown in Fig. 22, IC die 204A can be stacked on hybrid die 202A in a 3DIC die package 2300, as shown in Fig. 23.

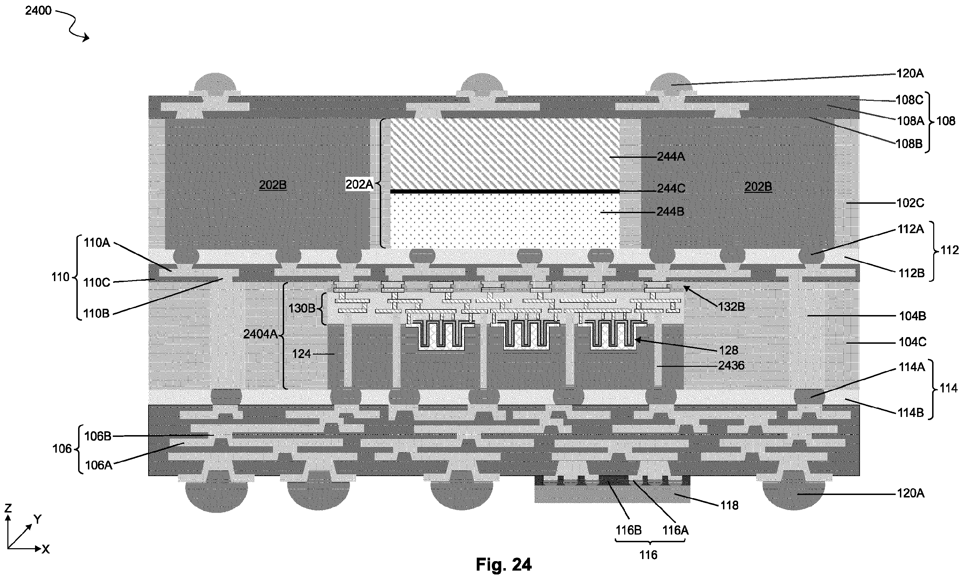

In some embodiments, instead of IC die 204A, hybrid die 202A can be bonded to a passive die 2404A with conductive bonding structures 112A to form the structure of 3DIC die package 2400, as shown in Fig. 24. Passive die 2404A can include trench capacitors 128 and conductive through-vias 2436.

It is to be appreciated that the Detailed Description section, and not the Abstract of the Disclosure section, is intended to be used to interpret the claims. The Abstract of the Disclosure section may set forth one or more but not all possible embodiments of the present disclosure as contemplated by the inventor(s), and thus, are not intended to limit the subjoined claims in any way.

Unless stated otherwise, the specific embodiments are not intended to limit the scope of claims that are drafted based on this disclosure to the disclosed forms, even where only a single example is described with respect to a particular feature. The disclosed embodiments are thus intended to be illustrative rather than restrictive, absent any statements to the contrary. The application is intended to cover such alternatives, modifications, and equivalents that would be apparent to a person skilled in the art having the benefit of this disclosure.

The foregoing disclosure outlines features of several embodiments so that those skilled in the art may better understand the aspects of the present disclosure. Those skilled in the art should appreciate that they may readily use the present disclosure as a basis for designing or modifying other processes and structures for carrying out the same purposes and/or achieving the same advantages of the embodiments introduced herein. Those skilled in the art should also realize that such equivalent constructions do not depart from the spirit and scope of the present disclosure, and that they may make various changes, substitutions, and alterations herein without departing from the spirit and scope of the present disclosure.

## Claims

1. A structure, comprising:
a first integrated circuit (IC) die, comprising:
a substrate comprising a first surface and a second surface opposite to the first surface,
a first active device disposed on the first surface of the substrate, and
a passive device disposed on the second surface of the substrate, wherein the passive device comprises:
a plurality of trenches disposed in the substrate and through the second surface of the substrate,
first and second conductive layers disposed in the plurality of trenches and on the second surface of the substrate, and
a first dielectric layer disposed between the first and second conductive layers; and
a second IC die comprising a second active device disposed on the first IC die.

2. The structure of claim 1, wherein the first IC die further comprises conductive through-vias disposed in the substrate, and
wherein the passive device is electrically connected to the first active device through the conductive through-vias.

3. The structure of claim 1 or 2, further comprising a redistribution layer disposed between the first and second IC dies, wherein the first IC die is bonded to the redistribution layer with the second surface of the substrate facing the second IC die.

4. The structure of one of the preceding claims, wherein a back-side of the passive device is separated from a back-side of the first active device by a portion of the substrate; and/or wherein the passive device and the first active device are non-overlapping with each other.

5. The structure of one of the preceding claims, wherein the first IC die further comprises a first contact layer disposed on the passive device,
wherein the second IC die comprises a second contact layer disposed on the second active device, and
wherein the first and second contact layers are electrically bonded to each other.

6. The structure of one of the preceding claims, wherein the passive device further comprises:
a doped region in the substrate and surrounding the plurality of trenches; and
a second dielectric layer disposed in the plurality of trenches and between the doped region and the first conductive layer.

7. The structure of one of the preceding claims, wherein the first IC die comprises a logic die or a memory die; and/or
wherein the second IC die comprises a system-on-chip (SoC) die.

8. The structure of one of the preceding claims, further comprising a memory die disposed on the first IC die and electrically bonded to the passive device.

9. A structure, comprising:
a first integrated circuit (IC) die comprising a first active device disposed on a first substrate; and
a second IC die disposed on the first IC die, wherein the second IC die comprises:
an active die comprising a second active device disposed on a second substrate,
a passive die comprising a passive device disposed on a first surface of a third substrate, wherein the passive device comprises:
a plurality of trenches disposed in the third substrate,
a first capacitor comprising a first conductive layer disposed in the plurality of trenches and a doped region surrounding the plurality of trenches, and
a second capacitor comprising the first conductive layer and a second conductive layer disposed on the first conductive layer; and
a hybrid bond interface comprising a conductive interface between metal pads of the active and passive dies and a non-conductive interface between dielectric layers of the active and passive dies.

10. The structure of claim 9, wherein the metal pad of the passive die is disposed on a second surface of the third substrate.

11. The structure of claim 10, wherein the first dielectric layer is disposed on the second active die, and
wherein the second dielectric layer is disposed on a second surface of the third substrate.

12. The structure of one of claims 9 to 11, wherein the passive die further comprises a conductive through-via disposed in the third substrate; and/or
wherein the first IC die further comprises a conductive through-via, and
wherein the passive die further comprises a contact layer disposed on the passive device and electrically connected to the conductive through-via.

13. The structure of one of claims 9 to 12, wherein the active die comprises a system-on-chip (SoC) die.

14. A method, comprising:
forming a passive die comprising a capacitor in a first substrate;
forming an active die comprising an active device in a second substrate;
performing a plasma process on top surfaces of the active and passive dies;
placing the active die on the passive die with the top surface of the active die facing the top surface of the passive die;
forming a hybrid bond at an interface between the top surfaces of the active and passive dies to form a hybrid die comprising the active and passive dies; and
bonding the hybrid die to an other active die.

15. The method of claim 14, wherein forming the hybrid bond comprises performing a thermal treatment on the active and passive dies; and/or
wherein forming the passive die comprises forming the capacitor in a plurality of trenches in the substrate; and/or
wherein forming the active die comprises forming a system-on-chip (SoC) die.
